# FASCICULE DE BREVET EUROPEEN

(11) **EP 0 575 480 B1**
(45) Date de publication et mention de la délivrance du brevet: **03.05.1995**
(21) Numéro de dépôt: 92907920.0
(22) Date de dépôt: 10.03.1992
(51) Int. Cl.: G11C 17/18

(54) **PROCEDE DE PROGRAMMATION POUR MEMOIRE INTEGREE, NOTAMMENT POUR CARTE A MEMOIRE**
VERFAHREN ZUM PROGRAMMIEREN EINES INTEGRIERTEN SPEICHERS, BESONDERS FÜR SPEICHERKARTEN
PROGRAMMING METHOD FOR INTEGRATED MEMORY, PARTICULARLY FOR SMART CARD

(30) Priorité: 14.03.1991 FR 9103106
(43) Date de publication de la demande: 29.12.1993
(73) Titulaire: GEMPLUS CARD INTERNATIONAL, F-13420 Gémenos (FR)
(72) Inventeur: BERTHOZAT, Michel, F-13290 Les Miles (FR); MORGAVI, Paul, F-13015 Marseille (FR)
(74) Mandataire: Ballot, Paul Denis Jacques
(86) Numéro de dépôt international: FR9200216
(87) Numéro de publication internationale: WO9216947

(56) Documents cités:
- EP-A- 0 149 402
- US-A- 3 835 458
- US-A- 4 937 465
- RECHERCHE, LA vol. 17, no. 176, Avril 1986, PARIS FR pages 470 - 479; M. UGONET AL: 'Les cartes à puce' see page 475, column 2, line 22 - line 36
- IEEE PROCEEDINGS ON RELIABILITY PHYSICS 2 Avril 1974, NEW YORK,US pages 82 -86; P. FRANKLIN ET AL: 'Reliability Aspects of Nichrome Fusible Link PROMs(Programmable Read Only Memories)' see page 83, left-hand column, line 12 - line 69
- ELECTRONIQUE INDUSTRIELLES. vol. 101, 1 Février 1986, PARIS FR pages 60 - 65;L. RENOUX: 'Deux Tendances en Programmation des PROM: Universalité et Emploi avec PC' see page 62, left-hand column, last figure see page 64, right-hand column, line 4 - line 66

## Description

La présente invention se rapporte aux procédés qui permettent de programmer les mémoires intégrées, notamment celles prévues pour les cartes à mémoire, pour y inscrire des données binaires de nature diverses.

Les cartes à mémoire, connues aussi sous le nom de cartes "à puce", sont des cartes au format carte de crédit, dans lesquelles est inséré au moins un circuit intégré comportant une mémoire et des circuits logiques d'exploitation pouvant éventuellement constituer un microprocesseur. Une partie au moins de la mémoire est programmée pour constituer une mémoire à lecture seule du type ROM, afin par exemple de personnaliser la carte. Pour cela, on programme la mémoire, puis on claque un fusible qui permet d'interdire toute inscription dans la zone ainsi programmée. On pourra ainsi lire cette zone, mais on ne pourra pas la reprogrammer. Le claquage d'un fusible permet en principe une protection très sûre, puisque normalement un fusible ne se reconstitue pas. Cependant, dans la pratique, on constate parfois, sinon la reconstitution, tout au moins le retour à un état relativement conducteur du fusible claqué, ce qui peut alors permettre une possibilité de reprogrammation de la zone normalement protégée. Le phénomène à l'origine de cet effet n'est pas très connu, et l'on pense qu'il y a des particules d'éléments conducteurs qui viennent reconstituer à plus ou moins long terme la connexion détruite, en raison des dimensions minuscules de cette connexion. Ces dimensions très réduites font que, pour claquer les fusibles, on n'applique la tension de claquage que pendant une durée limitée comprise entre 5 et 10 ms et on limite l'intensité maximale du courant de claquage à environ 30 mA, afin de ne pas risquer d'endommager les connexions avoisinant celle qui doit être claquée.

En outre les dispositifs actuellement utilisés pour claquer les fusibles sont très simples et essentiellement dédiés à un type de circuit. Ils ne permettent donc pas de modifier la tension de claquage à appliquer au circuit, ni la durée d'application de cette tension. Par ailleurs, pour respecter les limites précisées ci-dessus, le courant débité est faible. Enfin, le claquage n'est pas vérifié systématiquement.

Pour obtenir une programmation sûre des cartes à mémoire, l'invention propose un procédé de programmation pour mémoire intégrée à protection par fusible, dans lequel on applique à un fusible pendant une durée déterminée une tension de claquage correspondant à un courant limité à une intensité déterminée, caractérisé en ce que cette intensité est au moins égale à 1 Ampère.

D'autres particularités et avantages de l'invention apparaîtront clairement dans la description suivante, faite à titre d'exemple non limitatif en regard des figures annexées, qui représentent :
- la figure 1, un schéma général d'un ensemble de programmation et de protection selon l'invention ; et
- la figure 2, un schéma du dispositif de génération de la tension de claquage.

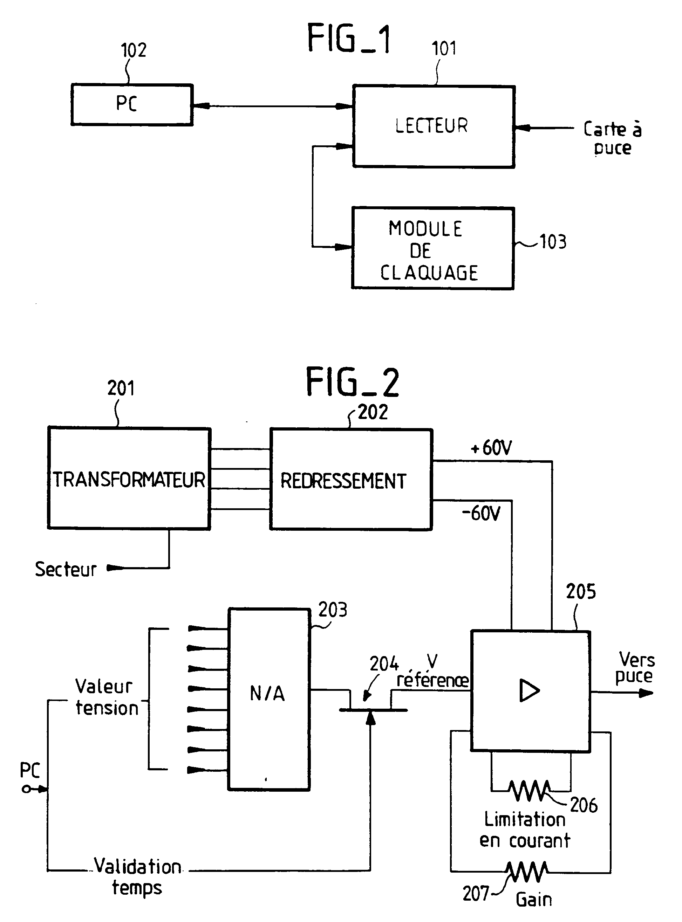

Sur la figure 1, un lecteur 101 de carte à puce répondant aux normes connues ISO 7816-3 est relié à un organe de commande 102, du type ordinateur personnel (PC) par exemple, et à un module de claquage 103 qui délivre les tensions de claquage des fusibles. Pour cela, le lecteur comprend des circuits d'interface qui permettent de commander le module 103 à partir du PC 102 et d'appliquer la tension obtenue à l'interface, connue en elle-même du lecteur avec la carte. Ces circuits d'interface comprennent des liaisons et des circuits logiques assemblés selon des techniques courantes. Ils permettent simplement de faciliter la liaison avec le PC et on pourrait très bien utiliser une liaison directe avec celui-ci, ce qui aurait toutefois pour inconvénient de nécessiter une sortie supplémentaire sur le PC, plus coûteuse que l'interface intégrée dans le lecteur.

Le schéma du module de claquage est détaillé sur la figure 2. Un transformateur 201, alimenté par le secteur, est relié à un circuit de redressement 202 pour obtenir deux tensions continues, + et - 60 V. Ces tensions sont actuellement les tensions extrêmes nécessaires, selon l'invention, pour le claquage des fusibles des mémoires à protection par fusible. Si dans l'avenir il fallait utiliser des tensions supérieures, on les obtiendrait sans difficultés.

La valeur de la tension à utiliser (dépendant du type de mémoire) arrive du PC, via le lecteur 101, sous la forme d'un mot binaire qui est appliqué à un convertisseur numérique analogique 203. Celui-ci délivre la tension de référence choisie par le PC à un transistor commutateur 204.

Ce transistor commutateur 204 est ouvert pendant la durée nécessaire, par une impulsion de validation de temps appliquée sur sa grille. Cette impulsion provient elle-même du lecteur 101, dans lequel elle a été calibrée à partir par exemple d'un autre mot binaire délivré par le PC.

Comme ni le convertisseur, ni le transistor commutateur, ne peuvent délivrer l'intensité nécessaire, la tension de référence est appliquée à un amplificateur de puissance 205, alimenté par le redresseur 202. Cet amplificateur délivre alors l'impulsion de claquage désirée vers la carte à puce, via le lecteur 101. La résistance de sortie de cet amplificateur est par exemple inférieure à 1 ohm et l'amplificateur est muni de moyens de limitation de courant, par exemple une résistance extérieure de réglage 206. En outre, si la tension de référence n'est égale qu'à une fraction de la tension de claquage, en raison par exemple des limitations du convertisseur 203, l'amplificateur 205 est muni de moyens de réglage de son gain, par exemple une résistance extérieure 207. Tous ces moyens sont connus en eux-mêmes.

Selon l'invention, la limitation du courant de claquage, et éventuellement la durée de l'impulsion, sont considérablement supérieures aux valeurs maximales couramment utilisées. Typiquement, on limite le courant à 2A et on applique la tension pendant 1 à 100 ms, de préférence pendant 30 à 100 ms. On obtient ainsi un claquage totalement irréversible des fusibles, sans provoquer aucun dégât dans les cellules avoisinant le fusible qui est claqué, contrairement aux craintes qui jusqu'à maintenant avaient mené aux limitations de l'art connu. Ce courant de 2A est généralement obtenu avec une tension de 50 V, qui se situe dans la gamme prévue plus haut.

Les programmes d'adressage des cellules de la mémoire et de commande (par tout ou rien) du claquage sont connus et il suffit de compléter le mot binaire qui commande le claquage par un nombre suffisant de bits, ou éventuellement par d'autres mots binaires, pour déterminer la durée et la tension de l'impulsion de claquage utilisée. Ceci ne présente aucune difficulté pour l'homme de l'art connaissant déjà le programme de claquage utilisé auparavant.

En outre, le programme pourra être complété par des instructions permettant de lire le contenu de la mémoire après sa programmation, ce qui est facile puisque le lecteur 101 permet justement cette lecture, sur commande du PC 102

Les valeurs de courant et de durée qui ont été indiquées ci-dessus sont des valeurs courantes pour des mémoires utilisées habituellement.

Compte tenu des différents modèles de mémoire, et de l'évolution des techniques, il est intéressant de pouvoir procéder à des tests afin de déterminer les valeurs optimales correspondant à un type particulier de mémoire, existant actuellement ou à venir. Pour cela, selon l'invention, on programme le PC 102 afin de claquer dans une, ou plusieurs, cartes à mémoire d'essai un nombre suffisamment significatif de fusibles, avec des tensions et des durées variées s'échelonnant au dessus et au dessous des valeurs indiquées ci-dessus. On claquera par exemple une dizaine de fusibles avec des valeurs variées de couples tension/temps.

Une fois la mémoire ainsi protégée, on procède à la l'écriture/lecture de son contenu (comme dans un test de mémoire), toujours par programmation du PC 102, pour vérifier que les fusibles claqués sont bien claqués, que les informations enregistrées dans la zone protégée n'ont pas été perturbées par l'opération, et que les zones non protégées ne sont pas détériorées. On répète cette opération d'écriture/lecture à plusieurs reprises à quelques jours d'intervalle afin de vérifier la stabilité des claquages. Finalement on choisit les valeurs de tension et de durée qui conviennent le mieux en fonction des résultats obtenus.

C'est en fait par cette méthode que les inventeurs sont parvenus aux valeurs décrites plus haut, qui conviennent dans les cas les plus courants actuellement.

## Revendications

1. Procédé de programmation pour mémoire intégrée à protection par fusible, dans lequel on applique à un fusible pendant une durée déterminée (204) une tension de claquage correspondant à un courant limité (206) à une intensité déterminée, caractérisé en ce que cette intensité est au moins égale à 1 Ampère.

2. Procédé selon la revendication 1, caractérisé en ce que la durée déterminée est comprise entre 1 et 100 ms.

3. Procédé selon la revendication 1, caractérisé en ce que la durée déterminée (204) est au moins égale à 30 ms.

4. Procédé selon l'une quelconque des revendications 1 à 3, caractérisé en ce que l'intensité (206) est sensiblement égale à 2 Ampères.

5. Procédé selon l'une quelconque des revendications 1 à 4, caractérisé en ce que la durée déterminée (204) est sensiblement égale à 100 ms.

6. Procédé selon l'une quelconque des revendications 1 à 5, caractérisé en ce que l'on utilise un ordinateur (102) pour commander la durée et la tension de l'impulsion de claquage.

7. Procédé selon la revendication 6, caractérisé en ce que l'on contrôle le claquage du fusible en effectuant une écriture/lecture de la mémoire à l'aide de l'ordinateur (102).

8. Procédé selon l'une quelconque des revendications 6 et 7, caractérisé en ce que l'on détermine un couple tension/durée (203,204) optimal de l'impulsion pour un modèle déterminé de fusible en claquant un ensemble de fusibles avec des couples tension/durée variables et en contrôlant par des écritures/lectures étalées dans le temps que les informations inscrites dans la zone protégée y sont toujours présentes et protégées.

9. Procédé selon l'une quelconque des revendications 1 à 8, caractérisé en ce que la mémoire est placée dans une carte à puce.

## Patentansprüche

1. Verfahren zum Programmieren eines integrierten Speichers mit Schmelzsicherungsschutz, bei dem an die Schmelzsicherung während einer vorgegebenen Zeitdauer (204) eine Durchschlagsspannung angelegt wird, die einem Strom (206) entspricht, der auf eine bestimmte Stärke begrenzt ist, dadurch gekennzeichnet, daß diese Stärke wenigstens gleich 1 Ampère ist.

2. Verfahren nach Anspruch 1, dadurch gekennzeichnet, daß die vorgegebene Zeitdauer zwischen 1 und 100 ms liegt.

3. Verfahren nach Anspruch 1, dadurch gekennzeichnet, daß die vorgegebene Zeitdauer (204) wenigstens gleich 30 ms ist.

4. Verfahren nach einem der Ansprüche 1 bis 3, dadurch gekennzeichnet, daß die Stärke (206) im wesentlichen gleich 2 Ampère ist.

5. Verfahren nach eiinem der Ansprüche 1 bis 4, dadurch gekennzeichnet, daß die vorgegebene Zeitdauer (204) im wesentlichen gleich 100 ms ist.

6. Verfahren nach einem der Ansprüche 1 bis 5, dadurch gekennzeichnet, daß ein Rechner (102) verwendet wird zur Steuerung der Zeitdauer und der Spannung des Durchschlagsimpulses.

7. Verfahren nach Anspruch 6, dadurch gekennzeichnet, daß der Durchschlag der Schmelzsicherung gesteuert wird, indem der Speicher mittels des Rechners (102) beschrieben/ausgelesen wird.

8. Verfahren nach einem der Ansprüche 6 und 7, dadurch gekennzeichnet, daß ein optimales Spannungs-/Zeitdauer-Paar (203, 204) für den Impuls für eine bestimmte Schmelzsicherung bestimmt wird, indem eine Anordnung von Schmelzsicherungen mit variablen Spannungs-/Zeitdauer Paaren beaufschlagt wird und wobei durch zeitlich getrennte Schreib-/Lese-Vorgänge überprüft wird, ob die im geschützten Bereich eingeschriebenen Informationen dort noch vorhanden und geschützt sind.

9. Verfahren nach einem der Ansprüche 1 bis 8, dadurch gekennzeichnet, daß der Speicher in einer Chipkarte angeordnet ist.

## Claims

1. Programming method for integrated memory with fuse protection, wherein a fuse is subjected for a certain period (204) to a breakdown voltage corresponding to a current limited (206) to a certain intensity, characterised by the fact that this intensity is at least equal to 1 ampere.

2. Method in accordance with claim 1, characterised by the fact that the definite period is between 1 and 100 ms.

3. Method in accordance with claim 1, characterised by the fact that the definite period (204) is at least equal to 30 ms.

4. Method in accordance with any one of claims 1 to 3, characterised by the fact that the intensity (206) is approximately equal to 2 amperes.

5. Method in accordance with any one of claims 1 to 4, characterised by the fact that the definite period (204) is substantially equal to 100 ms.

6. Method in accordance with any one of claims 1 to 5, characterised by the fact that a computer (102) is used for controlling the duration and voltage of the breakdown pulse.

7. Method in accordance with claim 6, characterised by the fact that the blowing of the fuse is monitored by means of a reading/writing of the memory by the aid of the computer (102).

8. Method in accordance with either of claims 6 and 7 characterised by the fact that an optimum voltage/duration (203, 204) combination for the pulse is determined for a certain given fuse model by causing the breakdown of a set of fuses with variable voltage/duration combinations and then verifying by reading/writing operations staggered over a period of time that the items of information written in the protected zone are always present therein and protected.

9. Method in accordance with any one of claims 1 to 8 characterised by the fact that the memory is positioned in a chip card.
